# EUROPEAN PATENT SPECIFICATION

(11) **EP 4 367 556 B1**
(45) Date of publication and mention of the grant of the patent: **29.07.2026**
(21) Application number: 22734498.3
(22) Date of filing: 02.06.2022
(51) Int. Cl.: G03F 7/20

(54) **METHOD FOR DECOUPLING SOURCES OF VARIATION RELATED TO SEMICONDUCTOR MANUFACTURING**
VERFAHREN ZUR ENTKOPPLUNG VON VARIATIONSQUELLEN IN DER HALBLEITERHERSTELLUNG
PROCÉDÉ DE DÉCOUPLAGE DE SOURCES DE VARIATION LIÉES À LA FABRICATION DE SEMI-CONDUCTEURS

(30) Priority: 09.07.2021 US 202163220309 P
(43) Date of publication of application: 15.05.2024
(73) Proprietor: ASML Netherlands B.V., 5500 AH Veldhoven (NL)
(72) Inventor: FREEMAN, Jill, Elizabeth, San Jose, CA 95134 (US); JAIN, Vivek, Kumar, San Jose, CA 95134 (US); PAO, Kuo-Feng, 5500 AH Veldhoven (NL); TEL, Wim, Tjibbo, 5500 AH Veldhoven (NL)
(74) Representative: ASML Netherlands B.V.
(86) International application number: PCT/EP2022/065027
(87) International publication number: WO 2023/280486

(56) References cited:
- EP-A1- 3 396 456
- US-A1- 2018 173 110
- JEONG JAESEUNG ET AL: "Understanding advanced DRAM edge placement error budget and opportunities for control", SPIE PROCEEDINGS; [PROCEEDINGS OF SPIE ISSN 0277-786X], SPIE, US, vol. 11325, 20 March 2020 (2020-03-20), pages 1132506 - 1132506, XP060130419, ISBN: 978-1-5106-3673-6, DOI: 10.1117/12.2551997

## Description

### FIELD

The present disclosure relates to method of improving the performance of semiconductor manufacturing process. The method may be used in connection with a lithographic apparatus or a metrology apparatus.

### BACKGROUND

A lithography apparatus is a machine that transfers a desired pattern onto a target portion of a substrate. Lithography apparatus can be used, for example, in the manufacture of integrated circuits (ICs). In that circumstance, a patterning device, which is alternatively referred to as a mask or a reticle, may be used to generate a circuit pattern corresponding to an individual layer of the IC, and this pattern can be imaged onto a target portion (e.g., comprising part of, one or several dies) on a substrate (e.g., a silicon wafer) that has a layer of radiation-sensitive material (resist). In general, a single substrate contains a network of adjacent target portions that are successively exposed. Known lithography apparatus include so-called steppers, in which each target portion is irradiated by exposing an entire pattern onto the target portion in one go, and so-called scanners, in which each target portion is irradiated by scanning the pattern through the beam in a given direction (the "scanning"-direction) while synchronously scanning the substrate parallel or anti parallel to this direction.

Prior to transferring the circuit pattern from the patterning device to the substrate, the substrate may undergo various processes, such as priming, resist coating and a soft bake. After exposure, the substrate may be subjected to other processes, such as a post-exposure bake (PEB), development, a hard bake and measurement/inspection of the transferred circuit pattern. This array of processes is used as a basis to make an individual layer of a device, e.g., an IC device. The substrate may then undergo various processes to produce the individual layer of the device, such as etching, ion-implantation (doping), metallization, oxidation, chemo-mechanical polishing, etc. If several layers are required in the device, then the whole procedure, or a variant thereof, can be repeated for each layer. Eventually, a device will be present in each target portion on the substrate. These devices are then separated from one another by a technique such as dicing or sawing, whence the individual devices can be mounted on a carrier, connected to pins, etc.

Thus, manufacturing semiconductor devices, typically involves processing a substrate (e.g., a semiconductor wafer) using a number of fabrication processes to form various features and multiple layers of the devices. Such layers and features are typically manufactured and processed using, e.g., deposition, lithography, etch, chemical-mechanical polishing, and ion implantation. Multiple devices may be fabricated on a plurality of dies on a substrate and then separated into individual devices. The device manufacturing typically includes a patterning process. A patterning process involves a patterning step, such as optical and/or nanoimprint lithography using a patterning device (e.g., a mask) in a lithographic apparatus, to transfer a pattern on the patterning device to a substrate and typically, but optionally, involves one or more related pattern processing steps, such as resist development by a development apparatus, baking of the substrate using a bake tool, etching using the pattern using an etch apparatus, etc.

EP 3 396 456 A1 discloses a method of monitoring a device manufacturing process, the method comprising obtaining an estimated time variation of a process parameter; determining, on the basis of the estimated time variation, a sampling plan for measurements to be performed on a plurality of substrates to obtain information about the process parameter; measuring substrates in accordance with the sampling plan to obtain a plurality of measurements; and determining an actual time variation of the process parameter on the basis of the measurements.

### SUMMARY

Semiconductor manufacturing involves monitoring and controlling one or more processes and apparatus used in the manufacturing so that nanoscale features of a circuit can be accurately printed on a substrate. For example, in a lithographic process is monitored to detect and flag process drifts or excursions, or outlier substrates by analyzing one or more key performance indicators (KPIs) data (e.g., local critical dimension uniformity (LCDU), failure rate, etc.), which are indicative of a process performance over time. These KPIs (e.g., local CD variation (LCDU), failure rate, etc.) are monitored by exposing substrates using a given process at regular intervals, measuring these substrates, and calculating the KPI data and monitoring a trend in the KPI data over a period of time. For example, in a high-volume manufacturing (HVM) setting, the given process may employ multiple tools and reticles which are expected to contribute to the KPI variation over time, and there may be other measurable process noise, such as mean critical dimension (CD) or dose, which also has an impact on the KPI to be measured. To account for these variations, different tools and reticles can be monitored separately with separate specification limits, and advanced process controls may be applied so that CD of features is as close as possible to a target CD.

According to the present disclosure, mechanisms are provided herein to capture process drifts, or outlier substrates that may be masking as meeting a KPI related specification. The present mechanisms decompose and filter out the contributions from a particular set of factors such as tools and reticles towards KPI variations and monitors residual KPI variations. Removing contributions from the various factors improves the signal to noise ratio of the residual KPI variations related to a semiconductor process over time. An improved signal to noise ratio in turn advantageously helps to identify process drifts in time, or outlier substrates.

According to the invention, there is provided a non-transitory computer-readable medium having instructions recorded thereon, the instructions, when executed by one or more processors, implementing a method for determining process drifts or outlier wafers over time in semiconductor manufacturing. The method involves obtaining a key performance indicator (KPI) variation (e.g., LCDU) characterizing a performance of a semiconductor process over time, and data associated with a set of factors associated with the semiconductor process; determining, using a model of the KPI and the data as input to the model, contributions of a first set of factors toward the KPI variation, the first set of factors breaching a statistical threshold; removing the contributions from the first set of factors toward the the KPI variation to obtain a residual KPI variation; and determining, based on the residual KPI variation, a residual value breaching a residual threshold, the residual value being indicative of process drifts in the semiconductor process over time or an outlier substrate corresponding to the residual value at a certain time.

In an embodiment, the model is configured based on the set of factors associated with the semiconductor manufacturing. The model is applied to the data to determine contributions from the set of factors toward the variation in the KPI. In an embodiment, an analysis of variance (ANOVA), an analysis of covariance (ANCOVA), or other statistical or modeling techniques can be applied to the statistical model to determine contributions of each of the set of factors toward the KPI variation.

In an embodiment, the set of factors comprises categorical variables, measurable parameters (e.g., dose, CD, focus, etc.), or a combination thereof. For example, the factors may include one or more of: a first categorical variable to characterize contribution of the plurality of lithography apparatuses towards the KPI variation; a second categorical variable to characterize contribution of the plurality of reticle towards the variation in the KPI; a third categorical variable to characterize contribution of the plurality of metrology tools towards the KPI variation; and a fourth variable comprising a measurable wafer parameter (e.g., mean CD) contributing toward the KPI variation.

In an embodiment, the method further includes detecting systematics (e.g., data patterns) in the residual KPI variation; responsive to detected systematics, determining a root cause associated with the systematics; and adjusting the model to include a factor associated with the root cause as a contributor towards the KPI variation. In an embodiment, the root cause indicates the residual KPI variations is caused by a characteristic of a process downstream to the semiconductor process, and/or a characteristic of a process upstream to the semiconductor process. Following the model adjustment, the detected systematics' contribution can advantageously be isolated from the subsequent residual KPI monitoring, which further improves the signal to noise ratio of the residual KPI variations.

### BRIEF DESCRIPTION OF THE DRAWINGS

Embodiments will now be described, by way of example only, with reference to the accompanying drawings in which:
Figure 1 schematically depicts a lithography apparatus, according to an embodiment;
Figure 2 shows example categories of processing parameters, according to an embodiment;
Figure 3 is a flow chart of a method for determining process drifts over time in semiconductor manufacturing, according to an embodiment;
Figure 4 is a plot of local critical dimension uniformity (LCDU) and mean CDs for different wafers patterned using different tools and reticles, according to an embodiment;
Figure 5A illustrates exemplary LCDU measured for different wafers, according to an embodiment;
Figure 5B illustrates exemplary modeled LCDU for different wafers, according to an embodiment;
Figure 5C illustrates exemplary residual LCDU for different wafers, according to an embodiment;
Figure 5D illustrates a pattern in another exemplary residual LCDU for different wafers, according to an embodiment;
Figure 6A illustrates a histogram of LCDU, according to an embodiment;
Figure 6B illustrates a histogram of residual LCDU where increased signal to noise ratio compared to LCDU of Figure 6A allows outliers to stand out, according to an embodiment;
Figure 7 is a block diagram of an exemplary computer system, according to an embodiment;
Figure 8 is a diagram of an exemplary extreme ultraviolet (EUV) lithographic projection apparatus, according to an embodiment;
Figure 9 is a more detailed view of the exemplary apparatus in Figure 8, according to an embodiment; and
Figure 10 is a more detailed view of the source collector module of the apparatus of Figure 8 and Figure 9, according to an embodiment.

### DETAILED DESCRIPTION

Although specific reference may be made in this text to the use of lithography apparatus in the manufacture of ICs, it should be understood that the lithography apparatus described herein may have other applications, such as the manufacture of integrated optical systems, guidance and detection patterns for magnetic domain memories, liquid-crystal displays (LCDs), thin film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm) and extreme ultra-violet (EUV) radiation (e.g. having a wavelength in the range of 5-20 nm), as well as particle beams, such as ion beams or electron beams.

The term "patterning device" used herein should be broadly interpreted as referring to a device that can be used to impart a radiation beam with a pattern in its cross-section such as to create a pattern in a target portion of the substrate. It should be noted that the pattern imparted to the radiation beam may not exactly correspond to the desired pattern in the target portion of the substrate. Generally, the pattern imparted to the radiation beam will correspond to a particular functional layer in a device being created in the target portion, such as an integrated circuit.

A patterning device may be transmissive or reflective. Examples of patterning device include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned.

The support structure holds the patterning device. It holds the patterning device in a way depending on the orientation of the patterning device, the design of the lithographic apparatus, and other conditions, such as for example whether or not the patterning device is held in a vacuum environment. The support can use mechanical clamping, vacuum, or other clamping techniques, for example electrostatic clamping under vacuum conditions. The support structure may be a frame or a table, for example, which may be fixed or movable as required and which may ensure that the patterning device is at a desired position, for example with respect to the projection system. Any use of the terms "reticle" or "mask" herein may be considered synonymous with the more general term "patterning device".

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "projection lens" herein may be considered as synonymous with the more general term "projection system".

The illumination system may also encompass various types of optical components, including refractive, reflective, and catadioptric optical components for directing, shaping, or controlling the beam of radiation, and such components may also be referred to below, collectively or singularly, as a "lens."

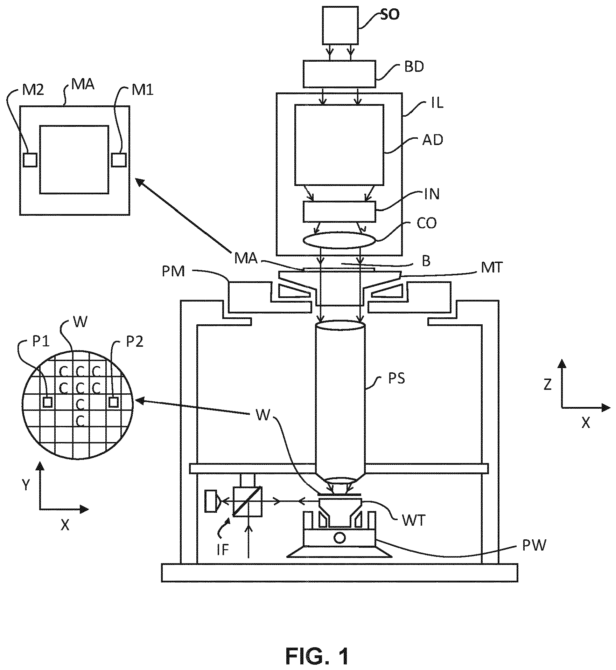

Figure 1 schematically depicts a lithography apparatus according to an embodiment. The apparatus comprises:
an illumination system (illuminator) IL to condition a beam PB of radiation (e.g. UV radiation or DUV radiation).
a support structure MT to support a patterning device (e.g. a mask) MA and connected to first positioning device PM to accurately position the patterning device with respect to item PL;
a substrate table (e.g. a wafer table) WT for holding a substrate (e.g. a resist coated wafer) W and connected to second positioning device PW for accurately positioning the substrate with respect to item PL; and
a projection system (e.g. a refractive projection lens) PL configured to image a pattern imparted to the radiation beam PB by patterning device MA onto a target portion C (e.g. comprising one or more dies) of the substrate W.

As here depicted, the apparatus is of a transmissive type (e.g. employing a transmissive mask). Alternatively, the apparatus may be of a reflective type (e.g. employing a programmable mirror array of a type as referred to above).

The illuminator IL receives a beam of radiation from a radiation source SO. The source and the lithography apparatus may be separate entities, for example when the source is an excimer laser. In such cases, the source is not considered to form part of the lithography apparatus and the radiation beam is passed from the source SO to the illuminator IL with the aid of a beam delivery system BD comprising for example suitable directing mirrors and/or a beam expander. In other cases the source may be an integral part of the apparatus, for example when the source is a mercury lamp. The source SO and the illuminator IL, together with the beam delivery system BD if required, may be referred to as a radiation system.

The illuminator IL may alter the intensity distribution of the beam. The illuminator may be arranged to limit the radial extent of the radiation beam such that the intensity distribution is non-zero within an annular region in a pupil plane of the illuminator IL. Additionally or alternatively, the illuminator IL may be operable to limit the distribution of the beam in the pupil plane such that the intensity distribution is non-zero in a plurality of equally spaced sectors in the pupil plane. The intensity distribution of the radiation beam in a pupil plane of the illuminator IL may be referred to as an illumination mode.

The illuminator IL may comprise adjuster AM configured to adjust the intensity distribution of the beam. Generally, at least the outer and/or inner radial extent (commonly referred to as σ-outer and σ-inner, respectively) of the intensity distribution in a pupil plane of the illuminator can be adjusted. The illuminator IL may be operable to vary the angular distribution of the beam. For example, the illuminator may be operable to alter the number, and angular extent, of sectors in the pupil plane wherein the intensity distribution is non-zero. By adjusting the intensity distribution of the beam in the pupil plane of the illuminator, different illumination modes may be achieved. For example, by limiting the radial and angular extent of the intensity distribution in the pupil plane of the illuminator IL, the intensity distribution may have a multi-pole distribution such as, for example, a dipole, quadrupole or hexapole distribution. A desired illumination mode may be obtained, e.g., by inserting an optic which provides that illumination mode into the illuminator IL or using a spatial light modulator.

The illuminator IL may be operable alter the polarization of the beam and may be operable to adjust the polarization using adjuster AM. The polarization state of the radiation beam across a pupil plane of the illuminator IL may be referred to as a polarization mode. The use of different polarization modes may allow greater contrast to be achieved in the image formed on the substrate W. The radiation beam may be unpolarized. Alternatively, the illuminator may be arranged to linearly polarize the radiation beam. The polarization direction of the radiation beam may vary across a pupil plane of the illuminator IL. The polarization direction of radiation may be different in different regions in the pupil plane of the illuminator IL. The polarization state of the radiation may be chosen in dependence on the illumination mode. For multi-pole illumination modes, the polarization of each pole of the radiation beam may be generally perpendicular to the position vector of that pole in the pupil plane of the illuminator IL. For example, for a dipole illumination mode, the radiation may be linearly polarized in a direction that is substantially perpendicular to a line that bisects the two opposing sectors of the dipole. The radiation beam may be polarized in one of two different orthogonal directions, which may be referred to as X-polarized and Y-polarized states. For a quadrupole illumination mode the radiation in the sector of each pole may be linearly polarized in a direction that is substantially perpendicular to a line that bisects that sector. This polarization mode may be referred to as XY polarization. Similarly, for a hexapole illumination mode the radiation in the sector of each pole may be linearly polarized in a direction that is substantially perpendicular to a line that bisects that sector. This polarization mode may be referred to as TE polarization.

In addition, the illuminator IL generally comprises various other components, such as an integrator IN and a condenser CO. The illuminator provides a conditioned beam of radiation PB, having a desired uniformity and intensity distribution in its cross section.

The radiation beam PB is incident on the patterning device (e.g. mask) MA, which is held on the support structure MT. Having traversed the patterning device MA, the beam PB passes through the lens PL, which focuses the beam onto a target portion C of the substrate W. With the aid of the second positioning device PW and position sensor IF (e.g. an interferometric device), the substrate table WT can be moved accurately, e.g. so as to position different target portions C in the path of the beam PB. Similarly, the first positioning device PM and another position sensor (which is not explicitly depicted in Figure 1) can be used to accurately position the patterning device MA with respect to the path of the beam PB, e.g. after mechanical retrieval from a mask library, or during a scan. In general, movement of the object tables MT and WT will be realized with the aid of a long-stroke module (coarse positioning) and a short-stroke module (fine positioning), which form part of the positioning device PM and PW. However, in the case of a stepper (as opposed to a scanner) the support structure MT may be connected to a short stroke actuator only, or may be fixed. Patterning device MA and substrate W may be aligned using patterning device alignment marks M1, M2 and substrate alignment marks P1, P2.

The projection system PL has an optical transfer function which may be non-uniform, which can affect the pattern imaged on the substrate W. For unpolarized radiation such effects can be fairly well described by two scalar maps, which describe the transmission (apodization) and relative phase (aberration) of radiation exiting the projection system PL as a function of position in a pupil plane thereof. These scalar maps, which may be referred to as the transmission map and the relative phase map, may be expressed as a linear combination of a complete set of basis functions. A particularly convenient set is the Zernike polynomials, which form a set of orthogonal polynomials defined on a unit circle. A determination of each scalar map may involve determining the coefficients in such an expansion. Since the Zernike polynomials are orthogonal on the unit circle, the Zernike coefficients may be determined by calculating the inner product of a measured scalar map with each Zernike polynomial in turn and dividing this by the square of the norm of that Zernike polynomial.

The transmission map and the relative phase map are field and system dependent. That is, in general, each projection system PL will have a different Zernike expansion for each field point (i.e. for each spatial location in its image plane). The relative phase of the projection system PL in its pupil plane may be determined by projecting radiation, for example from a point-like source in an object plane of the projection system PL (i.e. the plane of the patterning device MA), through the projection system PL and using a shearing interferometer to measure a wavefront (i.e. a locus of points with the same phase). A shearing interferometer is a common path interferometer and therefore, advantageously, no secondary reference beam is required to measure the wavefront. The shearing interferometer may comprise a diffraction grating, for example a two dimensional grid, in an image plane of the projection system (i.e. the substrate table WT) and a detector arranged to detect an interference pattern in a plane that is conjugate to a pupil plane of the projection system PL. The interference pattern is related to the derivative of the phase of the radiation with respect to a coordinate in the pupil plane in the shearing direction. The detector may comprise an array of sensing elements such as, for example, charge coupled devices (CCDs).

The diffraction grating may be sequentially scanned in two perpendicular directions, which may coincide with axes of a co-ordinate system of the projection system PL (x and y) or may be at an angle such as 45 degrees to these axes. Scanning may be performed over an integer number of grating periods, for example one grating period. The scanning averages out phase variation in one direction, allowing phase variation in the other direction to be reconstructed. This allows the wavefront to be determined as a function of both directions.

The projection system PL of a state of the art lithography apparatus LA may not produce visible fringes and therefore the accuracy of the determination of the wavefront can be enhanced using phase stepping techniques such as, for example, moving the diffraction grating. Stepping may be performed in the plane of the diffraction grating and in a direction perpendicular to the scanning direction of the measurement. The stepping range may be one grating period, and at least three (uniformly distributed) phase steps may be used. Thus, for example, three scanning measurements may be performed in the y-direction, each scanning measurement being performed for a different position in the x-direction. This stepping of the diffraction grating effectively transforms phase variations into intensity variations, allowing phase information to be determined. The grating may be stepped in a direction perpendicular to the diffraction grating (z direction) to calibrate the detector.

The transmission (apodization) of the projection system PL in its pupil plane may be determined by projecting radiation, for example from a point-like source in an object plane of the projection system PL (i.e. the plane of the patterning device MA), through the projection system PL and measuring the intensity of radiation in a plane that is conjugate to a pupil plane of the projection system PL, using a detector. The same detector as is used to measure the wavefront to determine aberrations may be used. The projection system PL may comprise a plurality of optical (e.g., lens) elements and may further comprise an adjustment mechanism PA configured to adjust one or more of the optical elements so as to correct for aberrations (phase variations across the pupil plane throughout the field). To achieve this, the adjustment mechanism PA may be operable to manipulate one or more optical (e.g., lens) elements within the projection system PL in one or more different ways. The projection system may have a co-ordinate system wherein its optical axis extends in the z direction. The adjustment mechanism PA may be operable to do any combination of the following: displace one or more optical elements; tilt one or more optical elements; and/or deform one or more optical elements. Displacement of optical elements may be in any direction (x, y, z or a combination thereof). Tilting of optical elements is typically out of a plane perpendicular to the optical axis, by rotating about axes in the x or y directions although a rotation about the z axis may be used for non-rotationally symmetric aspherical optical elements. Deformation of optical elements may include both low frequency shapes (e.g. astigmatic) and high frequency shapes (e.g. free form aspheres). Deformation of an optical element may be performed for example by using one or more actuators to exert force on one or more sides of the optical element and/or by using one or more heating elements to heat one or more selected regions of the optical element. In general, it may not be possible to adjust the projection system PL to correct for apodizations (transmission variation across the pupil plane). The transmission map of a projection system PL may be used when designing a patterning device (e.g., mask) MA for the lithography apparatus LA. Using a computational lithography technique, the patterning device MA may be designed to at least partially correct for apodizations.

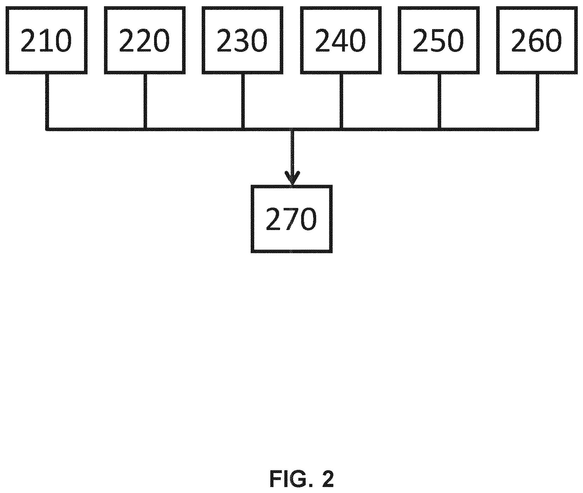

Parameters of the lithography process may be called "processing parameters." The lithography may include processes upstream and downstream to the actual exposure. Figure 2 shows example categories of the processing parameters 270. The first category may be parameters 210 of the lithography apparatus or any other apparatuses used in the lithography process. Examples of this category include parameters of the source, projection optics, substrate stage, etc. of a lithography apparatus. The second category may be parameters 220 of any procedures performed in the lithography process. Examples of this category include focus, dose, bandwidth, exposure duration, development temperature, chemical compositions used in development, etc. The third category may be parameters 230 of the design layout. Examples of this category may include shapes and locations of assist features, and adjustments applied by a resolution enhancement technique (RET). The fourth category may be parameters 240 of the substrate. Examples include characteristics of structures under a resist layer, chemical composition and physical dimensions of the resist layer. The fifth category may be characteristics 250 of temporal variations of some parameters of the lithography process. For example, the processing parameters may include characteristics of high frequency stage movements (e.g., frequency, amplitude, etc.), high frequency laser bandwidth changes (e.g., frequency, amplitude, etc.) and high frequency laser wavelength changes. These high frequency changes or movements are those above the response time of mechanisms to adjust the underlying parameters (e.g., stage position and laser intensity). The sixth category may be characteristics 260 of processes downstream to exposure, such as PEB, development, etching, deposition, doping and packaging.

The values of some or all of the processing parameters may be determined by a suitable method. For example, the values may be determined from data obtained with various substrate metrology tools. The values may be obtained from various sensors on the lithography apparatus. The values may also be from an operator of the lithography process.

Existing techniques monitor semiconductor manufacturing process based on one or more KPIs. For example, by monitoring KPI variations, process drifts or excursions may be detected and flagged to trigger root cause analysis of degradation of a process performance over time. As an example, a KPI is monitored by exposing wafers using a given process at regular intervals, measuring these wafers, calculating the KPI variation, and analyzing the KPI variation over time. For example, in a high-volume manufacturing setting, a semiconductor manufacturing process may employ multiple lithography tools and reticles, and there may be other measurable process noise, such as mean CD or dose, which has an impact on the KPI variation. To account for the KPI variation caused due to difference in tools and reticles, different tools and reticles may be monitored separately with separate specification limits. Upon detecting violation of specification limits, corrective actions may be applied (e.g., via advanced process controls) so as that the KPI is within desired limits. As an example, the corrective action may be applied to control printed wafer CDs as close as possible to target CDs. However, in KPI based monitoring and process control, certain wafers or process drifts may get masked as satisfying KPI specifications.

The present disclosure provides mechanisms to capture process drifts, or outlier substrates that may be masking as meeting a KPI related specification. In an embodiment, once the process drift is detected, relevant sources of the process drift may be determined more accurately. The present mechanisms decompose and filter out the contributions from various factors such as tools and reticles towards KPI variations and monitors residual KPI variations. Removing contributions from the various factors improves the signal to noise of the residual variations related to a semiconductor process over time. An improved signal to noise ratio in turn helps to identify process drifts in time, or the outlier substrates. The mechanisms herein are explained using the KPI of local CD uniformity (LCDU), which may be impacted by categorical independent variables, such as reticle, tool, and continuous independent variable mean CD. However, the present disclosure is not limited to LCDU, the same mechanisms can be applied using other KPIs (such as CD, exposure latitude (EL), or depth of focus (DOF)) and other combinations of independent variables.

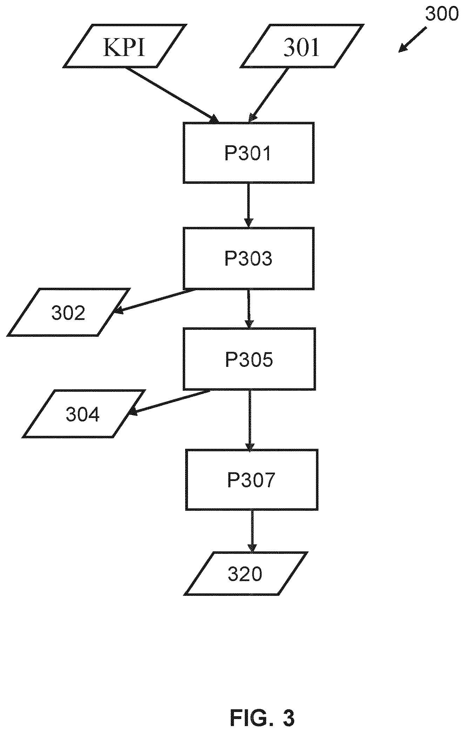

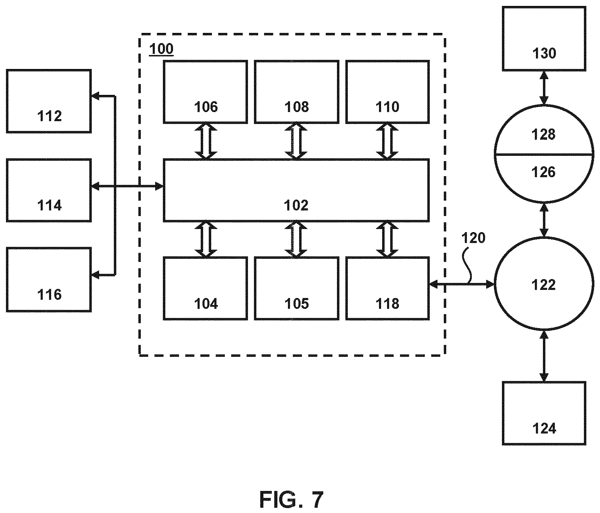

Figure 3 is a flow chart of an exemplary method for determining process drifts over time in semiconductor manufacturing according to an embodiment of the present disclosure. The method involves determining contributions of a set of selected variables or factors (e.g., tools, reticles, etc.) toward KPI variations. In some embodiments, these factors are measurable and quantifiable causes of the KPI variations. As such, when these contributions are removed, the remaining KPI variation may be a better indicator of process drifts or excursions of concern than the original KPI. An example implementation of the method 300 is discussed with respect to processes P301, P303, P305, and P307 below. The method 300 may be implemented as instructions on one or more processors (e.g., 104 in Figure 7).

Process P301 involves obtaining a key performance indicator (KPI) variation characterizing a performance of a semiconductor process over time, and data 301 of a set of factors associated with the semiconductor process. In an embodiment, the semiconductor manufacturing process may include a patterning process performed by one or more lithographic apparatus, a metrology process, a prepatterning process (e.g., CMP), and a post-patterning process (e.g., etching), or other semiconductor manufacturing related process.

In an embodiment, the KPI may be at least one of: LCDU associated with a pattern imaged on a substrate via the patterning process; an edge placement error associated with associated with a pattern imaged on the substrate via the patterning process; an overlay associated with the pattern imaged on the substrate via the patterning process; or any other suitable KPIs related to process monitoring or characterization. In an embodiment, the KPI data may be obtained over a period of time, where a plurality of lithography apparatuses, a pre-/post-patterning process apparatus, a plurality of reticles, a plurality of metrology tools, and/or one or more measurable parameters may be employed during the semiconductor manufacturing process.

In an embodiment, the set of factors that contribute to the KPI variation may be categorical variables, measurable parameters (e.g., see Figure 2), or a combination thereof. For example, the set of factors may be at least one of: a first categorical variable to characterize contribution of the plurality of lithography apparatuses towards the KPI variation; a second categorical variable to characterize contribution of the plurality of reticle towards the variation in the KPI; a third categorical variable to characterize contribution of the plurality of metrology tools towards the KPI variation; and a fourth variable comprising a measurable substrate parameter contributing toward the KPI variation. In an embodiment, the measurable parameter comprises at least one of: mean critical dimension (CD) of a pattern printed on a substrate or a portion of the substrate; dose of a lithographic apparatus; and focus of the lithographic apparatus. Additional examples are illustrated in Figure 2.

Referring back to Figure 3, process P303 involves using a model of the KPI and the data 301 as input to the model to determine contributions of a first set of factors 302 toward the KPI variation. In an embodiment, the first set of factors 302 refers to factors having a statistical value that breach a statistical threshold. For example, the values associated with the first set of factors 302 may be considered statistically significant (e.g., the p-value greater than 0.9). In an embodiment, the factors, whose contribution may not be statistically significant, may not be removed from the model. In other words, the contributions from statistically insignificant factors can be included as part of the residual in the model.

In an embodiment, the model may be a statistical model configured to decompose the KPI variation into as a function of the set of factors and a residual term. In an embodiment, the model may be a linear or regression model configured to decompose the KPI variation into a function of the set of factors and a residual term. In an embodiment, a machine learning model configured to receive the data 301 related to the set of factors as input and generate the residual KPI variation 304 as output. Other models configured to decompose the KPI variation may also be within the scope of present disclosure.

In an embodiment, the determining of the first set of factors 302 involves configuring the model based on the set of factors associated with the semiconductor manufacturing (e.g., the patterning process). The model is applied to the data 301 associated with the set of factors to determine contributions from the set of factors toward the KPI variation. For example, the determining of the first set of factors 302 may involve applying an analysis of variance (ANOVA) or an analysis of covariance (ANCOVA) technique to the statistical model to determine contributions of each of the set of factors toward the KPI variation. The present disclosure is not limited to a particular technique for determining contributions. Other techniques may also be applied.

As an example, the contributions and statistical significance of three sources of the KPI variation (e.g., LCDU variation) may be considered. An ANOVA, or ANCOVA may be performed on the dataset using a statistical model of the KPI (e.g., LCDU) such as: *LCDU* = µ *+ aᵢ + βⱼ* + *γ* * *CDᵢⱼₖ + εᵢⱼₖ*.

In the above LCDU model, *i* refers to a reticle and *j* refers to a tool, *a*ᵢ and *βⱼ* indicates contributions from the categorical variables the reticle and the tool, respectively. The term CD refers to CD data of the k^{th} substrate, which is processed using a reticle *i* and a tool *j.* The term *εᵢⱼₖ* refers to the residual KPI variation. In an embodiment, the ANCOVA will generate p-values to indicate whether there is a statistically significant difference between LCDU based on the reticles and the tools, after accounting for the continuous co-variate mean CD.

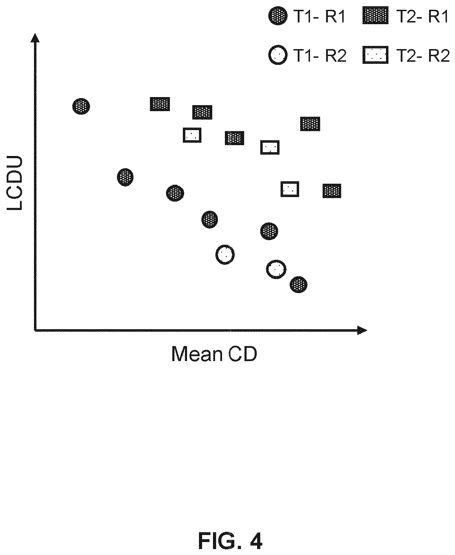

Figure 4 illustrates an exemplary scatterplot of LCDU against mean CD for a set of substrates being monitored. Each point represents a measured CD and LCDU for a single substrate, and the datapoint's shape and pattern indicate a tool and a reticle used to process a particular substrate. For example, the tool may be T1 or T2, and the reticle may be R1 or R2. The plot shows a significant amount of variation in the measured LCDU may be explained by the mean CD. The ANCOVA using the above LCDU model indicates much of the LCDU variation may be accounted for by the three variables a tool, a reticle, and mean CD.

Referring back to Figure 3, process P305 involves removing contributions from the first set of factors 302 toward the KPI variation to obtain a residual KPI variation 304. For example, referring to the LCDU equation above, after the contributions of the tool, the reticle, and the mean CD have been quantified (e.g., by applying ANOCVA), their contribution can be removed from the dataset associated with the set of factors. For example, removing from the dataset is achieved by subtracting the modeled KPI values from the measured KPI values or by any other mathematical or computational techniques or operations. The residual (*εᵢⱼₖ*) KPI variation is the remaining variation which may not be accounted for by tool-to-tool differences, reticle-to-reticle differences, and/or mean CD. In other words, the LCDU variation has been decomposed into (i) a component which can be accounted for by the tool, the reticle, and the mean CD, and (ii) a residual component which represents the variation caused by one or more processes and by process drifts over time. If the contribution from a factor is not statistically significant, then such factor and its contributions may not be removed from the dataset and included as part of the residual KPI variation 304.

Process P307 involves determining, based on the residual KPI variation 304, a residual value 320 breaching a residual threshold. The residual value 320 indicates process drifts in the semiconductor process over time or an outlier substrate corresponding to the residual value 320 at a certain time. For example, the residual KPI variation 304 may be trended over time instead of the original KPI to identify any outliers. The outliers indicate that the residual KPI variation 304 at a certain time has increased more than a threshold value, thus a substrate corresponding to that time or outlier residual value 320 should be further analyzed to process issues so that appropriate control adjustments may be made to the process. As another example, the outlier residual value 320 may indicate that the residual value 320 increases due to some process drifts caused over a period of time. Thus, when the drift begins relative to prior residual values, process parameters or events causing the drift may be monitored and appropriate action may be taken. For example, a reticle may be cleaned, a cooling system of a mask may be activated, or other changes in settings of the patterning process may be monitored as it may be causes of drifts or particular patterns in the residual KPI variations. Other examples causing a pattern in residual may be a resist batch may be replaced, changes to an upstream or an downstream process such as cleaning or etching.

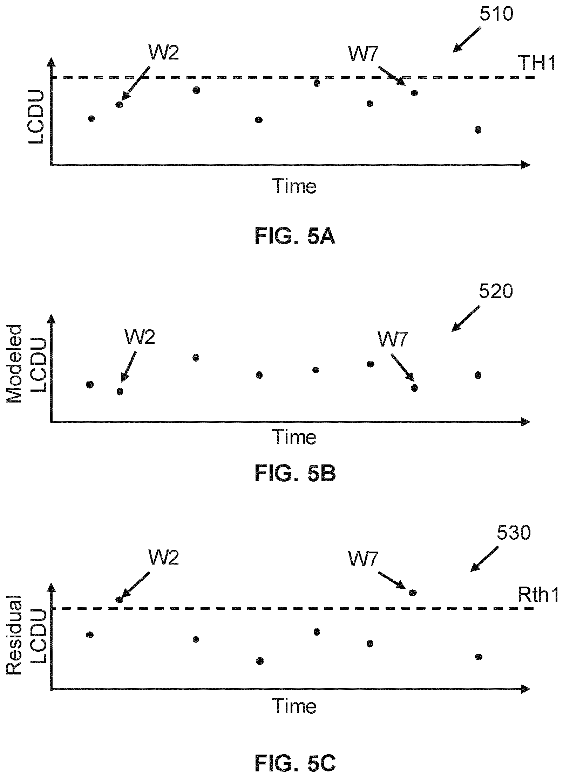

Figures 5A-5C illustrate exemplary trend charts for measured LCDU 510, modeled LCDU 520, and residual LCDU 530 over time. The modeled LCDU 520 may be an estimated LCDU for the given tool, reticle, and mean CD from ANCOVA. The residual LCDU 530 may the remaining variation when the contributions from the tool, reticle and mean CD are removed. Each point in the trend chart correspond to a substrate (e.g., W2 and W7). As can be seen, based on the threshold limits assigned for the LCDU 510, the modeled LCDU 520 and the residual LCDU 530, different substrates may be flagged as outliers in the residual LCDU 530 as compared to the measured LCDU 510 trend chart. However, as mentioned earlier, since certain measurable causes (e.g., not related to a process drift of concern) of variation have been removed, the residual can be a better indicator of process drifts or excursions of concern. For example, in LCDU 510, wafers W2 and W7 do not exceed an outlier threshold value TH1 assigned to the LCDU trend chart. However, the residual LCDU 530 indicates that the wafers W2 and W7 are outliers, as residual values corresponding to these wafers W2 and W7 exceed a residual threshold Rth1. Hence, the wafers W2 and W7 were masked as having no issues, but the residual LCDU indicates otherwise.

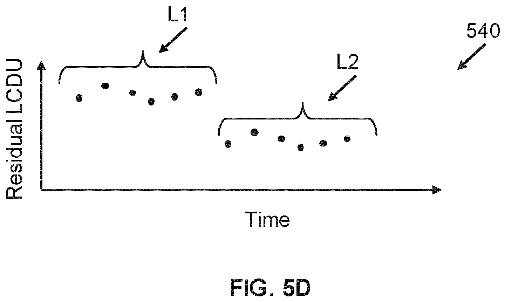

In an embodiment, the method 300 may further include detecting systematics (e.g., a data pattern) in the residual KPI variation 304; responsive to detected systematics, determining a root cause associated with the systematics; and adjusting the model based on the root cause. For example, in the residual KPI variation 304, a data pattern may evolve overtime. A root cause associated with such a data pattern may be considered as a factor, which can be added to the model. For example, upon cleaning a reticle, the residual KPI variation 304 may include a level change (e.g., see Figure 5D) from values in a first range to values in a second range. For example, in Figure 5D, a residual KPI variation associated with a set of substrates L1 is at a first level, and the with a second set of substrates L2 is at a second level. Such level change may be caused due to a reticle cleaning occurrence. As such, the reticle cleaning may be included as a categorical variable in the model to quantify effects of reticle cleaning and potentially remove contributions of the reticle cleaning from the KPI variations. As an example, other causes may be reticle or pellicle degradation or replacement.

In an embodiment, the root cause analysis indicates outliers or process drifts detected using the residual KPI variation 304 is caused by a characteristic of a process downstream to the semiconductor manufacturing process. For example, downstream of an exposure of the substrate. In an embodiment, the root cause analysis indicates the residual KPI variation 304 is caused by a characteristic of a process upstream to the semiconductor manufacturing process. For example, upstream of an exposure of the substrate. In an embodiment, the detecting of the systematics involves identifying a shift in a level of the residual KPI variation 304 over a period of time. In an embodiment, the detecting of the systematics involves executing a statistical model configured to identify systematics (e.g., data patterns) in the residual KPI variation 304.

In an embodiment, the method 300 may further involve capturing new data 301 related to the set of factors associated with the semiconductor manufacturing process at a regular interval or continuously; and updating the residual KPI variation 304 based on the captured data 301. In an embodiment, the model may be updated based on captured data and detected systematics.

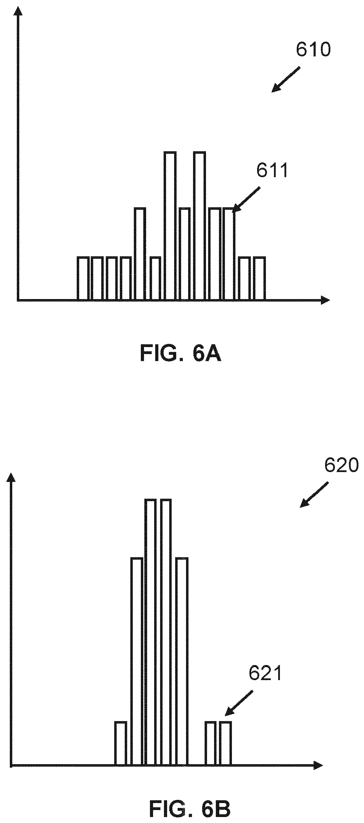

In an embodiment, the residual KPI variation 304 comprises a higher signal to noise ratio compared to a signal to noise ratio in measured KPI. For example, Figure 6 illustrates histograms 610 of measured LCDU and residual LCDU 620. The histograms clearly show outliers 621 in the residual LCDU histogram 620, however, these are hidden within the noise 611 of the LCDU histogram 610. These histograms illustrate the residual LCDU 620 improves the signal/noise of process variation over time.

It can be understood that the mechanisms discussed herein are not limited to particular KPIs or a set of factors contributing towards KPI variations. In some embodiments, KPI such as LCDU may be measured for a single dose and focus condition. For this KPI, mean CD of a pattern printed on a substrate(s) may be used as a continuous co-variate to account for variations in the substrate(s) centering due to noise in exposure dose or other factors. In some embodiments, other KPIs, such as exposure latitude and depth of focus, may be calculated based on data collected from a plurality of dose and focus conditions across a focus-exposure matrix (FEM) used to print a substrate. For these "substrate-based" KPIs, control for variations in the substrate(s) centering may not be needed. As such, only categorical variables for an exposure tool and a reticle may be used in the model. Accordingly, as discussed herein, when ANOVA is performed contributions from the reticle and exposure tool may be determined and later removed to compute the residual KPI variation.

In some embodiment, the KPIs may be a process condition-based metric, a substrate-based metric, or other semiconductor related metric. In an embodiment, a condition-based KPI may be determined at single focus and dose conditions (e.g., nominal conditions) for a substrate. For example, LCDU may be determined as average of 3-sigma of CD measurements per image or field of view (FOV) at nominal condition. As another example, CDU may be determined as 3-sigma of CD measurements across all images/FOV at nominal condition. As yet another example, a modeled failure rate may be modelled by process window metrology at nominal condition. In the model of these KPI, categorical variables may correspond to a plurality of lithography tools, reticles, or other tools used in the semiconductor manufacturing. In an embodiment, some KPIs may include common categorical variables such as for reticles, while in some other KPIs, the categorical variables may be different. The choice of the categorical variable may depend on the amount of KPI variation that a particular categorical variable contributes to. In an embodiment, the categorical variables may be chosen based on heuristic experience.

In an embodiment, a substrate-based KPI may be determined based on all focus-dose conditions data measured on a substrate. For example, a first KPI (referred as CDPW_EL) may be an exposure latitude determined from a maximum area of an ellipse fitted inside a CD process window. The ellipse may be constrained to a fixed depth of focus. For the first KPI, the categorical variable may correspond to reticles, but not the lithography tools. A second KPI (denoted as CDPW_DoF) may be a depth of focus determined from a maximum area of an ellipse fitted inside a CD process window. The ellipse may be constrained to a fixed exposure latitude. For the second KPI, the categorical variable may correspond to reticles, but not the lithography tools. A third KPI may be a maximum area of the ellipse fit inside a CD process window. For the first KPI, the categorical variables may correspond to reticles and the lithography tools. A fourth KPI (denoted as FRPW EL) may be an exposure latitude determined from a maximum area of an ellipse fitted inside a failure rate process window. The ellipse can be constrained to a fixed depth of focus. A fifth KPI (denoted as FRPW DoF) may be a depth of focus determined from a maximum area of an ellipse fitted inside a failure rate process window. The ellipse can be constrained to a fixed exposure latitude. A sixth KPI (denoted as FRPW Max Ellipse Area) may be a maximum area of an ellipse fitted inside a failure process window. A seventh KPI may be an exposure latitude determined from a maximum area of an ellipse fitted inside an overlapped CD and failure rate process window. The ellipse can be constrained to a fixed depth of focus. A eighth KPI may be a depth of focus determined from a maximum area of an ellipse fitted inside an overlapped CD and failure rate process window. The ellipse can be constrained to a fixed exposure latitude. A ninth KPI may be a maximum area of an ellipse fitted inside an overlapped CD and failure process window. A tenth KPI may be a dose required to obtain a target CD, and may be calculated from CD model which is a function of dose. An eleventh KPI may be dose sensitivity at best energy or best focus. The dose sensitivity may be computed as a change in CD with change in dose, calculated at best energy/best focus from CD model. A twelfth KPI may be a minimum failure rate across all focus and dose conditions as modeled by a process window metrology approach. In the above list of KPIs, categorical variables for each are not specified, but will be appreciated by those with ordinary skills in the art. The respective categorical variables may be appropriately based on likely contributions from particular lithography tools, reticles, metrology tools, etc. It can be understood that one or more of the aforementioned KPIs may be used and corresponding residual KPI variations may be determined as discussed herein.

Figure 7 is a block diagram that illustrates an exemplary computer system 100 configured to assist in implementing methods and flows disclosed herein in accordance with an embodiment of the present disclosure. Computer system 100 includes a bus 102 or other communication mechanism for communicating information, and a processor 104 (or multiple processors 104 and 105) coupled with bus 102 for processing information. Computer system 100 also includes a main memory 106, such as a random access memory (RAM) or other dynamic storage device, coupled to bus 102 for storing information and instructions to be executed by processor 104. Main memory 106 also may be used for storing temporary variables or other intermediate information during execution of instructions to be executed by processor 104. Computer system 100 further includes a read only memory (ROM) 108 or other static storage device coupled to bus 102 for storing static information and instructions for processor 104. A storage device 110, such as a magnetic disk or optical disk, is provided and coupled to bus 102 for storing information and instructions.

Computer system 100 may be coupled via bus 102 to a display 112, such as a cathode ray tube (CRT) or flat panel or touch panel display for displaying information to a computer user. An input device 114, including alphanumeric and other keys, is coupled to bus 102 for communicating information and command selections to processor 104. Another type of user input device is cursor control 116, such as a mouse, a trackball, or cursor direction keys for communicating direction information and command selections to processor 104 and for controlling cursor movement on display 112. This input device typically has two degrees of freedom in two axes, a first axis (e.g., x) and a second axis (e.g., y), that allows the device to specify positions in a plane. A touch panel (screen) display may also be used as an input device.

According to one embodiment, portions of the process may be performed by computer system 100 in response to processor 104 executing one or more sequences of one or more instructions contained in main memory 106. Such instructions may be read into main memory 106 from another computer-readable medium, such as storage device 110. Execution of the sequences of instructions contained in main memory 106 causes processor 104 to perform the process steps described herein. One or more processors in a multi-processing arrangement may also be employed to execute the sequences of instructions contained in main memory 106. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 104 for execution. Such a medium may take many forms, including but not limited to, non-volatile media, volatile media, and transmission media. Non-volatile media include, for example, optical or magnetic disks, such as storage device 110. Volatile media include dynamic memory, such as main memory 106. Transmission media include coaxial cables, copper wire and fiber optics, including the wires that comprise bus 102. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 104 for execution. For example, the instructions may initially be borne on a magnetic disk of a remote computer. The remote computer can load the instructions into its dynamic memory and send the instructions over a telephone line using a modem. A modem local to computer system 100 can receive the data on the telephone line and use an infrared transmitter to convert the data to an infrared signal. An infrared detector coupled to bus 102 can receive the data carried in the infrared signal and place the data on bus 102. Bus 102 carries the data to main memory 106, from which processor 104 retrieves and executes the instructions. The instructions received by main memory 106 may optionally be stored on storage device 110 either before or after execution by processor 104.

Computer system 100 also desirably includes a communication interface 118 coupled to bus 102. Communication interface 118 provides a two-way data communication coupling to a network link 120 that is connected to a local network 122. For example, communication interface 118 may be an integrated services digital network (ISDN) card or a modem to provide a data communication connection to a corresponding type of telephone line. As another example, communication interface 118 may be a local area network (LAN) card to provide a data communication connection to a compatible LAN. Wireless links may also be implemented. In any such implementation, communication interface 118 sends and receives electrical, electromagnetic or optical signals that carry digital data streams representing various types of information.

Network link 120 typically provides data communication through one or more networks to other data devices. For example, network link 120 may provide a connection through local network 122 to a host computer 124 or to data equipment operated by an Internet Service Provider (ISP) 126. ISP 126 in turn provides data communication services through the worldwide packet data communication network, now commonly referred to as the "Internet" 128. Local network 122 and Internet 128 both use electrical, electromagnetic or optical signals that carry digital data streams. The signals through the various networks and the signals on network link 120 and through communication interface 118, which carry the digital data to and from computer system 100, are example forms of carrier waves transporting the information.

Computer system 100 can send messages and receive data, including program code, through the network(s), network link 120, and communication interface 118. In the Internet example, a server 130 might transmit a requested code for an application program through Internet 128, ISP 126, local network 122 and communication interface 118. One such downloaded application may provide for the illumination optimization of the embodiment, for example. The received code may be executed by processor 104 as it is received, and/or stored in storage device 110, or other non-volatile storage for later execution. In this manner, computer system 100 may obtain application code in the form of a carrier wave.

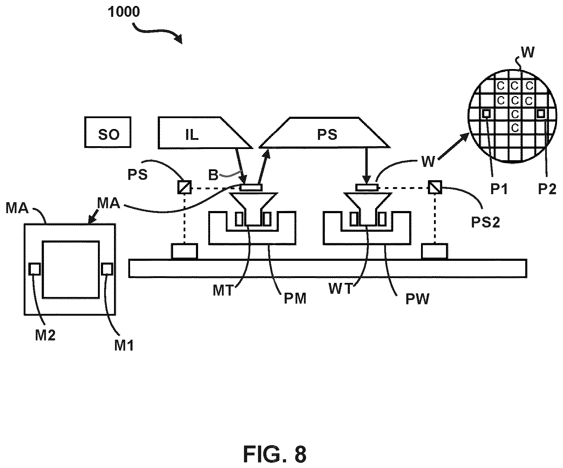

Figure 8 depicts another exemplary lithographic projection apparatus 1000 in accordance with an embodiment of the present disclosure. Apparatus 1000 includes:
- a source collector module SO to provide radiation.
- an illumination system (illuminator) IL configured to condition a radiation beam B (e.g. EUV radiation) from the source collector module SO.
- a support structure (e.g. a mask table) MT constructed to support a patterning device (e.g. a mask or a reticle) MA and connected to a first positioner PM configured to accurately position the patterning device;
- a substrate table (e.g. a wafer table) WT constructed to hold a substrate (e.g. a resist coated wafer) W and connected to a second positioner PW configured to accurately position the substrate; and
- a projection system (e.g. a reflective projection system) PS configured to project a pattern imparted to the radiation beam B by patterning device MA onto a target portion C (e.g. comprising one or more dies) of the substrate W.

As here depicted, the apparatus 1000 is of a reflective type (e.g. employing a reflective mask). It is to be noted that because most materials are absorptive within the EUV wavelength range, the patterning device may have multilayer reflectors comprising, for example, a multi-layer stack of molybdenum and silicon. In one example, the multi-stack reflector has a 40 layer pairs of Molybdenum and Silicon where the thickness of each layer is a quarter wavelength. Even smaller wavelengths may be produced with X-ray lithography. Since most material is absorptive at EUV and x-ray wavelengths, a thin piece of patterned absorbing material on the patterning device topography (e.g., a TaN absorber on top of the multi-layer reflector) defines where features would print (positive resist) or not print (negative resist).

Referring to Figure 8, the illuminator IL receives an extreme ultra violet radiation beam from the source collector module SO. Methods to produce EUV radiation include, but are not necessarily limited to, converting a material into a plasma state that has at least one element, e.g., xenon, lithium or tin, with one or more emission lines in the EUV range. In one such method, often termed laser produced plasma ("LPP") the plasma can be produced by irradiating a fuel, such as a droplet, stream or cluster of material having the line-emitting element, with a laser beam. The source collector module SO may be part of an EUV radiation system including a laser, not shown in Figure 8, for providing the laser beam exciting the fuel. The resulting plasma emits output radiation, e.g., EUV radiation, which is collected using a radiation collector, disposed in the source collector module. The laser and the source collector module may be separate entities, for example when a CO2 laser is used to provide the laser beam for fuel excitation.

In such cases, the laser is not considered to form part of the lithographic apparatus and the radiation beam is passed from the laser to the source collector module with the aid of a beam delivery system comprising, for example, suitable directing mirrors and/or a beam expander. In other cases the radiation source may be an integral part of the source collector module, for example when the radiation source is a discharge produced plasma EUV generator, often termed as a DPP radiation source.

The illuminator IL may comprise an adjuster for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as facetted field and pupil mirror devices. The illuminator may be used to condition the radiation beam, to have a desired uniformity and intensity distribution in its cross section.

The radiation beam B is incident on the patterning device (e.g., mask) MA, which is held on the support structure (e.g., mask table) MT, and is patterned by the patterning device. After being reflected from the patterning device (e.g. mask) MA, the radiation beam B passes through the projection system PS, which focuses the beam onto a target portion C of the substrate W. With the aid of the second positioner PW and position sensor PS2 (e.g. an interferometric device, linear encoder or capacitive sensor), the substrate table WT can be moved accurately, e.g. so as to position different target portions C in the path of the radiation beam B. Similarly, the first positioner PM and another position sensor PS1 can be used to accurately position the patterning device (e.g. mask) MA with respect to the path of the radiation beam B. Patterning device (e.g. mask) MA and substrate W may be aligned using patterning device alignment marks M1, M2 and substrate alignment marks P1, P2.

The depicted apparatus 1000 could be used in at least one of the following modes:
1. In step mode, the support structure (e.g. mask table) MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed.
2. In scan mode, the support structure (e.g. mask table) MT and the substrate table WT are scanned synchronously while a pattern imparted to the radiation beam is projected onto a target portion C (i.e. a single dynamic exposure). The velocity and direction of the substrate table WT relative to the support structure (e.g. mask table) MT may be determined by the (de-)magnification and image reversal characteristics of the projection system PS.
3. In another mode, the support structure (e.g. mask table) MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

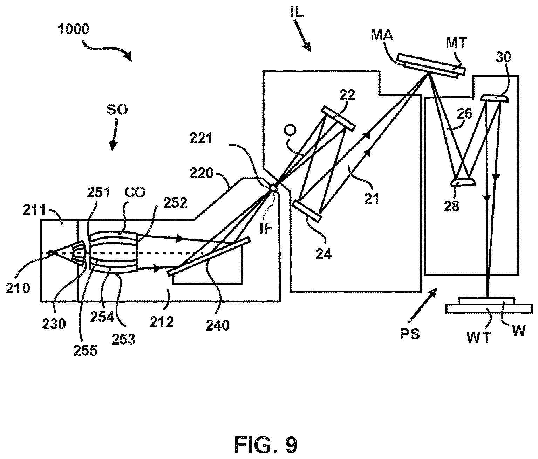

Figure 9 shows the apparatus 1000 in more detail, including the source collector module SO, the illumination system IL, and the projection system PS. The source collector module SO is constructed and arranged such that a vacuum environment can be maintained in an enclosing structure 220 of the source collector module SO. An EUV radiation emitting plasma 210 may be formed by a discharge produced plasma radiation source. EUV radiation may be produced by a gas or vapor, for example Xe gas, Li vapor or Sn vapor in which the very hot plasma 210 is created to emit radiation in the EUV range of the electromagnetic spectrum. The very hot plasma 210 is created by, for example, an electrical discharge causing an at least partially ionized plasma. Partial pressures of, for example, 10 Pa of Xe, Li, Sn vapor or any other suitable gas or vapor may be required for efficient generation of the radiation. In an embodiment, a plasma of excited tin (Sn) is provided to produce EUV radiation.

The radiation emitted by the hot plasma 210 is passed from a source chamber 211 into a collector chamber 212 via an optional gas barrier or contaminant trap 230 (in some cases also referred to as contaminant barrier or foil trap) which is positioned in or behind an opening in source chamber 211. The contaminant trap 230 may include a channel structure. Contamination trap 230 may also include a gas barrier or a combination of a gas barrier and a channel structure. The contaminant trap or contaminant barrier 230 further indicated herein at least includes a channel structure, as known in the art.

The collector chamber 211 may include a radiation collector CO which may be a so-called grazing incidence collector. Radiation collector CO has an upstream radiation collector side 251 and a downstream radiation collector side 252. Radiation that traverses collector CO can be reflected off a grating spectral filter 240 to be focused in a virtual source point IF along the optical axis indicated by the dot-dashed line 'O'. The virtual source point IF is commonly referred to as the intermediate focus, and the source collector module is arranged such that the intermediate focus IF is located at or near an opening 221 in the enclosing structure 220. The virtual source point IF is an image of the radiation emitting plasma 210.

Subsequently the radiation traverses the illumination system IL, which may include a facetted field mirror device 22 and a facetted pupil mirror device 24 arranged to provide a desired angular distribution of the radiation beam 21, at the patterning device MA, as well as a desired uniformity of radiation intensity at the patterning device MA. Upon reflection of the beam of radiation 21 at the patterning device MA, held by the support structure MT, a patterned beam 26 is formed and the patterned beam 26 is imaged by the projection system PS via reflective elements 28, 30 onto a substrate W held by the substrate table WT.

More elements than shown may generally be present in illumination optics unit IL and projection system PS. The grating spectral filter 240 may optionally be present, depending upon the type of lithographic apparatus. Further, there may be more mirrors present than those shown in the Figures, for example there may be 1- 6 additional reflective elements present in the projection system PS than shown in Figure 9.

Collector optic CO, as illustrated in Figure 9, is depicted as a nested collector with grazing incidence reflectors 253, 254 and 255, just as an example of a collector (or collector mirror). The grazing incidence reflectors 253, 254 and 255 are disposed axially symmetric around the optical axis O and a collector optic CO of this type is desirably used in combination with a discharge produced plasma radiation source.

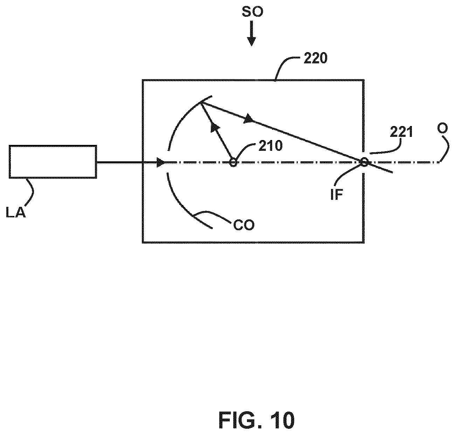

Alternatively, the source collector module SO may be part of an LPP radiation system as shown in Figure 10. A laser LAS is arranged to deposit laser energy into a fuel, such as xenon (Xe), tin (Sn) or lithium (Li), creating the highly ionized plasma 210 with electron temperatures of several 10's of eV. The energetic radiation generated during de-excitation and recombination of these ions is emitted from the plasma, collected by a near normal incidence collector optic CO and focused onto the opening 221 in the enclosing structure 220.

The concepts disclosed herein may simulate or mathematically model any generic imaging system for imaging sub wavelength features, and may be especially useful with emerging imaging technologies capable of producing wavelengths of an increasingly smaller size. Emerging technologies already in use include EUV (extreme ultra violet) lithography that is capable of producing a 193nm wavelength with the use of an ArF laser, and even a 157nm wavelength with the use of a Fluorine laser. Moreover, EUV lithography is capable of producing wavelengths within a range of 20-5nm by using a synchrotron or by hitting a material (either solid or a plasma) with high energy electrons in order to produce photons within this range.

While the concepts disclosed herein may be used for imaging on a substrate such as a silicon wafer, it shall be understood that the disclosed concepts may be used with any type of lithographic imaging systems, e.g., those used for imaging on substrates other than silicon wafers.

Although specific reference may be made in this text to the use of embodiments in the manufacture of ICs, it should be understood that the embodiments herein may have many other possible applications. For example, it may be employed in the manufacture of integrated optical systems, guidance and detection patterns for magnetic domain memories, liquid-crystal displays (LCDs), thin film magnetic heads, micromechanical systems (MEMs), etc. The skilled artisan will appreciate that, in the context of such alternative applications, any use of the terms "reticle", "wafer" or "die" herein may be considered as synonymous or interchangeable with the more general terms "patterning device", "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create, for example, a multi-layer IC, so that the term substrate used herein may also refer to a substrate that already contains multiple processed layers.

In the present document, the terms "radiation" and "beam" as used herein encompass all types of electromagnetic radiation, including ultraviolet radiation (e.g. with a wavelength of about 365, about 248, about 193, about 157 or about 126 nm) and extreme ultra-violet (EUV) radiation (e.g. having a wavelength in the range of 5-20 nm), as well as particle beams, such as ion beams or electron beams.

The terms "optimizing" and "optimization" as used herein refers to or means adjusting a patterning apparatus (e.g., a lithography apparatus), a patterning process, etc. such that results and/or processes have more desirable characteristics, such as higher accuracy of projection of a design pattern on a substrate, a larger process window, etc. Thus, the term "optimizing" and "optimization" as used herein refers to or means a process that identifies one or more values for one or more parameters that provide an improvement, e.g. a local optimum, in at least one relevant metric, compared to an initial set of one or more values for those one or more parameters. "Optimum" and other related terms should be construed accordingly. In an embodiment, optimization steps can be applied iteratively to provide further improvements in one or more metrics.

Aspects of the invention can be implemented in any convenient form. For example, an embodiment may be implemented by one or more appropriate computer programs which may be carried on an appropriate carrier medium which may be a tangible carrier medium (e.g. a disk) or an intangible carrier medium (e.g. a communications signal). Embodiments of the invention may be implemented using suitable apparatus which may specifically take the form of a programmable computer running a computer program arranged to implement a method as described herein. Thus, embodiments of the disclosure may be implemented in hardware, firmware, software, or any combination thereof. Embodiments of the disclosure may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic disk storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc.

In block diagrams, illustrated components are depicted as discrete functional blocks, but embodiments are not limited to systems in which the functionality described herein is organized as illustrated. The functionality provided by each of the components may be provided by software or hardware modules that are differently organized than is presently depicted, for example such software or hardware may be intermingled, conjoined, replicated, broken up, distributed (e.g. within a data center or geographically), or otherwise differently organized. The functionality described herein may be provided by one or more processors of one or more computers executing code stored on a tangible, non-transitory, machine readable medium. In some cases, third party content delivery networks may host some or all of the information conveyed over networks, in which case, to the extent information (e.g., content) is said to be supplied or otherwise provided, the information may be provided by sending instructions to retrieve that information from a content delivery network.

Unless specifically stated otherwise, as apparent from the discussion, it is appreciated that throughout this specification discussions utilizing terms such as "processing," "computing," "calculating," "determining" or the like refer to actions or processes of a specific apparatus, such as a special purpose computer or a similar special purpose electronic processing/computing device.

It should be understood that the description and the drawings are not intended to limit the present disclosure to the particular form disclosed. The invention is defined by the appended claims.

As used throughout this application, the word "may" is used in a permissive sense (i.e., meaning having the potential to), rather than the mandatory sense (i.e., meaning must). The words "include", "including", and "includes" and the like mean including, but not limited to. As used throughout this application, the singular forms "a," "an," and "the" include plural referents unless the content explicitly indicates otherwise. Thus, for example, reference to "an" element or "a" element includes a combination of two or more elements, notwithstanding use of other terms and phrases for one or more elements, such as "one or more." The term "or" is, unless indicated otherwise, nonexclusive, i.e., encompassing both "and" and "or." Terms describing conditional relationships, e.g., "in response to X, Y," "upon X, Y,", "if X, Y," "when X, Y," and the like, encompass causal relationships in which the antecedent is a necessary causal condition, the antecedent is a sufficient causal condition, or the antecedent is a contributory causal condition of the consequent, e.g., "state X occurs upon condition Y obtaining" is generic to "X occurs solely upon Y" and "X occurs upon Y and Z." Such conditional relationships are not limited to consequences that instantly follow the antecedent obtaining, as some consequences may be delayed, and in conditional statements, antecedents are connected to their consequents, e.g., the antecedent is relevant to the likelihood of the consequent occurring. Statements in which a plurality of attributes or functions are mapped to a plurality of objects (e.g., one or more processors performing steps A, B, C, and D) encompasses both all such attributes or functions being mapped to all such objects and subsets of the attributes or functions being mapped to subsets of the attributes or functions (e.g., both all processors each performing steps A-D, and a case in which processor 1 performs step A, processor 2 performs step B and part of step C, and processor 3 performs part of step C and step D), unless otherwise indicated. Further, unless otherwise indicated, statements that one value or action is "based on" another condition or value encompass both instances in which the condition or value is the sole factor and instances in which the condition or value is one factor among a plurality of factors. Unless otherwise indicated, statements that "each" instance of some collection have some property should not be read to exclude cases where some otherwise identical or similar members of a larger collection do not have the property, i.e., each does not necessarily mean each and every. References to selection from a range includes the end points of the range.

In the above description, any processes, descriptions or blocks in flowcharts should be understood as representing modules, segments or portions of code which include one or more executable instructions for implementing specific logical functions or steps in the process, and alternate implementations are included within the scope of the exemplary embodiments of the present advancements in which functions can be executed out of order from that shown or discussed, including substantially concurrently or in reverse order, depending upon the functionality involved, as would be understood by those skilled in the art.

## Claims

1. A non-transitory computer-readable medium having instructions recorded thereon, the instructions, when executed by one or more processors, implementing a method for determining process drifts over time in semiconductor manufacturing, the method comprising:
obtaining a key performance indicator (KPI) variation characterizing a performance of a semiconductor process over time, and data associated with a set of factors associated with the semiconductor process;
determining, using a model of the KPI and the data as input to the model, contributions of a first set of factors toward the KPI variation, the first set of factors breaching a statistical threshold;
removing the contributions from the first set of factors toward the KPI variation to obtain a residual KPI variation; and
determining, based on the residual KPI variation, a residual value breaching a residual threshold, the residual value being indicative of process drifts in the semiconductor process over time or an outlier substrate corresponding to the residual value at a certain time.

2. The medium of claim 1, wherein the determining of the first set of factors comprises:
configuring the model based on the set of factors associated with the semiconductor manufacturing; and
applying the model to the data to determine an amount of contribution from the set of factors toward the variation in the KPI.

3. The medium of claim 1, wherein the model comprises at one of:
a statistical model configured to decompose the KPI into a function of the set of factors and a residual term; and
a machine learning model configured to receive the data related to the set of factors as input, and generate the residual KPI variation as output.

4. The medium of claim 3, wherein determining of the first set of factors comprises:
applying an analysis of variance (ANOVA) or an analysis of covariance (ANCOVA) technique to the statistical model to determine contributions of each of the set of factors toward the KPI variation.

5. The medium of claim 1, wherein the KPI is at least one of:
local critical dimension uniformity (LCDU) associated with a pattern imaged on a substrate via a patterning process;
an edge placement error associated with associated with a pattern imaged on the substrate via the patterning process; and
an overlay associated with the pattern imaged on the substrate via the patterning process.

6. The medium of claim 1, wherein the KPI variation is obtained by using plurality of lithography apparatuses, a plurality of process apparatuses, a plurality of reticles, a plurality of metrology tools, and/or one or more measurable parameters.

7. The medium of claim 1, wherein the set of factors comprises at least one of:
a first categorical variable to characterize contribution of the plurality of lithography apparatuses towards the KPI variation;
a second categorical variable to characterize contribution of the plurality of reticle towards the variation in the KPI;
a third categorical variable to characterize contribution of the plurality of metrology tools towards the KPI variation; and
a fourth variable comprising a measurable wafer parameter contributing toward the KPI variation.

8. The medium of claim 7, wherein the measurable parameter comprises at least one of: mean critical dimension of a pattern; dose of a lithographic apparatus; and focus of the lithographic apparatus.

9. The medium of claim 1, further comprises:
detecting systematics in the residual KPI variation;
responsive to detected systematics, determining a root cause associated with the systematics; and
adjusting the model to include a factor associated with the root cause as a contributor towards the KPI variation.

10. The medium of claim 9, wherein the root cause indicates the residual KPI variations is caused by a characteristic of a process downstream to the semiconductor process.

11. The medium of claim 9, wherein the root cause indicates the residual KPI variations is caused by a characteristic of a process upstream to the semiconductor process.

12. The medium of claim 9, wherein the detecting of the systematics comprises:
identifying a shift in a level of the residual KPI variation over a period of time.

13. The medium of claim 9, wherein the detecting of the systematics comprises:
executing a statistical model configured to identify systematics in the residual KPI variation.

14. The medium of claim 1, further comprises:
capturing, at a regular interval or continuously, data related to the set of factors associated with the semiconductor process; and
updating the residual KPI variation based on the captured data.

15. The medium of claim 1, wherein the residual KPI variation comprises a higher signal to noise ratio compared to a signal to noise ratio in measured KPI.

## Patentansprüche

1. Ein nichttransitorisches, computerlesbares Medium, auf dem Anweisungen aufgezeichnet sind, wobei die Anweisungen bei Ausführung durch einen oder mehrere Prozessoren ein Verfahren zum Bestimmen von Prozessdriften im Zeitverlauf bei der Halbleiterherstellung implementieren, wobei das Verfahren Folgendes beinhaltet:
Erhalten einer Haupt-Leistungsindikator(KPI)-Variation, die eine Leistung eines Halbleiterprozesses im Zeitverlauf beschreibt, und von Daten, die mit einem Satz Faktoren assoziiert sind, welche mit dem Halbleiterprozess assoziiert ist;
Bestimmen, unter Verwendung eines Modells des KPI und der Daten als Eingang in das Modell, von Beiträgen eines ersten Satzes Faktoren zu der KPI- Variation, wobei der erste Satz Faktoren einen statistischen Schwellenwert überschreitet;
Entfernen der Beiträge aus dem ersten Satz Faktoren zu der KPI-Variation, um eine KPI-Restvariation zu erhalten; und
Bestimmen, auf der Basis der KPI-Restvariation, eines Restwertes, der einen Restschwellenwert überschreitet, wobei der Restwert für Prozessdriften in dem Halbleiterprozess im Zeitverlauf oder ein Ausreißersubstrat, das dem Restwert zu einem gewissen Zeitpunkt entspricht, indikativ ist.

2. Medium gemäß Anspruch 1, wobei das Bestimmen des ersten Satzes Faktoren Folgendes beinhaltet:
Konfigurieren des Modells auf der Basis des Satzes Faktoren, die mit der Halbleiterherstellung assoziiert sind; und
Anwenden des Modells auf die Daten, um eine Beitragsmenge von dem Satz Faktoren zu der Variation des KPI zu bestimmen.

3. Medium gemäß Anspruch 1, wobei das Modell eines von Folgendem beinhaltet:
ein statistisches Modell, das konfiguriert ist, um den KPI in eine Funktion des Satzes Faktoren und einen Restterm zu zerlegen; und
ein Maschinenlernmodell, das konfiguriert ist, um die Daten, die sich auf den Satz Faktoren beziehen, als Eingang zu empfangen und die KPI-Restvariation als Ausgang zu erzeugen.

4. Medium gemäß Anspruch 3, wobei das Bestimmen des ersten Satzes Faktoren Folgendes beinhaltet:
Anwenden einer Technik der Varianzanalyse (ANOVA) oder der Kovarianzanalyse (ANCOVA) auf das statistische Modell, um Beiträge jedes Faktors des Satzes Faktoren zu der KPI-Variation zu bestimmen.

5. Medium gemäß Anspruch 1, wobei der KPI mindestens eines von Folgendem ist:
lokale Gleichmäßigkeit der kritischen Abmessung (LCDU), die mit einem Muster assoziiert ist, das mittels eines Musteraufbringungsprozesses auf ein Substrat abgebildet wird;
ein Kantenplatzierungsfehler, der mit einem Muster assoziiert ist, das mittels des Musteraufbringungsprozesses auf das Substrat abgebildet wird; und
ein Overlay, das mit dem Muster, das mittels des Musteraufbringungsprozesses auf das Substrat abgebildet wird, assoziiert ist.

6. Medium gemäß Anspruch 1, wobei die KPI-Variation durch die Verwendung einer Vielzahl von Lithographiegeräten, einer Vielzahl von Prozessgeräten, einer Vielzahl von Retikeln, einer Vielzahl von Messwerkzeugen und/oder eines oder mehrerer messbarer Parameter erhalten wird.

7. Medium gemäß Anspruch 1, wobei der Satz Faktoren mindestens eines von Folgendem beinhaltet:
eine erste kategorische Variable, um den Beitrag der Vielzahl von Lithographiegeräten zu der KPI-Variation zu beschreiben;
eine zweite kategorische Variable, um den Beitrag der Vielzahl von Retikeln zu der Variation des KPI zu beschreiben;
eine dritte kategorische Variable, um den Beitrag der Vielzahl von Messwerkzeugen zu der KPI-Variation zu beschreiben; und
eine vierte Variable, die einen messbaren Waferparameter beinhaltet, der zu der KPI-Variation beiträgt.

8. Medium gemäß Anspruch 7, wobei der messbare Parameter mindestens eines von Folgendem beinhaltet: mittlere kritische Abmessung eines Musters; Dosis eines lithographischen Geräts; und Fokus des lithographischen Geräts.

9. Medium gemäß Anspruch 1, das ferner Folgendes beinhaltet:
Detektieren einer Systematik in der KPI-Restvariation;
als Reaktion auf die detektierte Systematik, Bestimmen einer zugrunde liegenden Ursache, die mit der Systematik assoziiert ist; und
Anpassen des Modells, sodass es einen mit der zugrunde liegenden Ursache assoziierten Faktor als Beiträger zu der KPI-Variation einschließt.

10. Medium gemäß Anspruch 9, wobei die zugrunde liegende Ursache indiziert, dass die KPI-Restvariation durch ein Merkmal eines dem Halbleiterprozess nachgeschalteten Prozesses verursacht wird.

11. Medium gemäß Anspruch 9, wobei die zugrunde liegende Ursache indiziert, dass die KPI-Restvariation durch ein Merkmal eines dem Halbleiterprozess vorgeschalteten Prozesses verursacht wird.

12. Medium gemäß Anspruch 9, wobei das Detektieren der Systematik Folgendes beinhaltet:
Identifizieren einer Verschiebung eines Niveaus der KPI-Restvariation über einen Zeitraum.

13. Medium gemäß Anspruch 9, wobei das Detektieren der Systematik Folgendes beinhaltet:
Ausführen eines statistischen Modells, das konfiguriert ist, um eine Systematik in der KPI-Restvariation zu identifizieren.

14. Medium gemäß Anspruch 1, das ferner Folgendes beinhaltet:
Erfassen, in einem regelmäßigen Intervall oder kontinuierlich, von Daten, die sich auf den Satz Faktoren beziehen, welche mit dem Halbleiterprozess assoziiert sind; und
Aktualisieren der KPI-Restvariation auf der Basis der erfassten Daten.

15. Medium gemäß Anspruch 1, wobei die KPI-Restvariation im Vergleich zu einem Signal-Rausch-Verhältnis im gemessenen KPI ein höheres Signal-Rausch-Verhältnis beinhaltet.

## Revendications

1. Un support lisible par ordinateur non transitoire sur lequel sont enregistrées des instructions, les instructions implémentant, lorsqu'elles sont exécutées par un ou plusieurs processeurs, une méthode pour déterminer des dérives de procédé au fil du temps lors de la fabrication de semi-conducteurs, la méthode comprenant :
l'obtention d'une variation d'indicateur clé de performance (KPI) caractérisant une performance d'un procédé semi-conducteur au fil du temps, et de données associées à un ensemble de facteurs associés au procédé semi-conducteur ;
la détermination, en utilisant un modèle du KPI et les données comme entrée dans le modèle, de contributions d'un premier ensemble de facteurs à la variation de KPI, le premier ensemble de facteurs ne respectant pas un seuil statistique ;
le retrait des contributions apportées par le premier ensemble de facteurs à la variation de KPI afin d'obtenir une variation de KPI résiduelle ; et
la détermination, sur la base de la variation de KPI résiduelle, d'une valeur résiduelle ne respectant pas un seuil résiduel, la valeur résiduelle étant indicative de dérives de procédé dans le procédé semi-conducteur au fil du temps ou d'un substrat aberrant correspondant à la valeur résiduelle à un certain temps.

2. Le support de la revendication 1, dans lequel la détermination du premier ensemble de facteurs comprend :
la configuration du modèle sur la base de l'ensemble de facteurs associés à la fabrication de semi-conducteurs ; et
l'application du modèle aux données afin de déterminer une étendue de la contribution apportée par l'ensemble de facteurs à la variation du KPI.

3. Le support de la revendication 1, dans lequel le modèle comprend un modèle parmi :
un modèle statistique configuré pour décomposer le KPI en une fonction de l'ensemble de facteurs et un terme résiduel ; et
un modèle d'apprentissage machine configuré pour recevoir les données relatives à l'ensemble de facteurs comme entrée, et générer la variation de KPI résiduelle comme sortie.

4. Le support de la revendication 3, dans lequel la détermination du premier ensemble de facteurs comprend :
l'application d'une technique d'analyse de variance (ANOVA) ou d'analyse de covariance (ANCOVA) au modèle statistique pour déterminer des contributions de chaque facteur de l'ensemble de facteurs à la variation de KPI.

5. Le support de la revendication 1, dans lequel le **KPI** est au moins un élément parmi :
une uniformité de dimension critique locale (LCDU) associée à un motif imagé sur un substrat via un procédé servant à conformer selon un motif ;
une erreur de placement de bord associée à un motif imagé sur le substrat via le procédé servant à conformer selon un motif ; et
un overlay associé au motif imagé sur le substrat via le procédé servant à conformer selon un motif.

6. Le support de la revendication 1, dans lequel la variation de **KPI** est obtenue en utilisant une pluralité d'appareils de lithographie, une pluralité d'appareils de procédé, une pluralité de réticules, une pluralité d'outils de métrologie, et/ou un ou plusieurs paramètres mesurables.

7. Le support de la revendication 1, dans lequel l'ensemble de facteurs comprend au moins une variable parmi :
une première variable catégorique pour caractériser la contribution de la pluralité d'appareils de lithographie à la variation de KPI ;
une deuxième variable catégorique pour caractériser la contribution de la pluralité de réticules à la variation du KPI ;
une troisième variable catégorique pour caractériser la contribution de la pluralité d'outils de métrologie à la variation de KPI ; et
une quatrième variable comprenant un paramètre de tranche mesurable contribuant à la variation de KPI.

8. Le support de la revendication 7, dans lequel le paramètre mesurable comprend au moins un élément parmi : une dimension critique moyenne d'un motif ; une dose d'un appareil lithographique ; et un focus de l'appareil lithographique.

9. Le support de la revendication 1, comprenant en sus :
la détection de systématiques dans la variation de KPI résiduelle ;
en réponse à des systématiques détectées, la détermination d'une cause à la racine associée aux systématiques ; et
l'ajustement du modèle pour inclure un facteur associé à la cause à la racine comme contributeur à la variation de KPI.

10. Le support de la revendication 9, dans lequel la cause à la racine indique que la variation de KPI résiduelle est causée par une caractéristique d'un procédé en aval du procédé semi-conducteur.

11. Le support de la revendication 9, dans lequel la cause à la racine indique que la variation de KPI résiduelle est causée par une caractéristique d'un procédé en amont du procédé semi-conducteur.

12. Le support de la revendication 9, dans lequel la détection des systématiques comprend :
l'identification d'un décalage dans un niveau de la variation de KPI résiduelle sur une période de temps.

13. Le support de la revendication 9, dans lequel la détection des systématiques comprend :
l'exécution d'un modèle statistique configuré pour identifier des systématiques dans la variation de KPI résiduelle.

14. Le support de la revendication 1, comprenant en sus :
la capture, à intervalle régulier ou en continu, de données relatives à l'ensemble de facteurs associés au procédé semi-conducteur ; et
la mise à jour de la variation de KPI résiduelle sur la base des données capturées.

15. Le support de la revendication 1, dans lequel la variation de KPI résiduelle comprend un rapport signal sur bruit plus élevé comparé à un rapport signal sur bruit dans le KPI mesuré.
